Europäisches Patentamt

European Patent Office

Office européen des brevets

(11) Numéro de publication : **0 321 329 B1**

(12) # FASCICULE DE BREVET EUROPEEN

(45) Date de publication du fascicule du brevet :
**13.11.91 Bulletin 91/46**

(51) Int. Cl.⁵ : **H03B 5/18**

(21) Numéro de dépôt : **88403151.9**

(22) Date de dépôt : **12.12.88**

(54) Oscillateur doubleur de fréquence accordé par varactors.

(30) Priorité : **18.12.87 FR 8717709**

(43) Date de publication de la demande :
**21.06.89 Bulletin 89/25**

(45) Mention de la délivrance du brevet :
**13.11.91 Bulletin 91/46**

(84) Etats contractants désignés :
**DE GB IT SE**

(56) Documents cités :
**EP-A- 0 203 663
EP-A- 0 242 292
DE-A- 1 906 943
FR-A- 2 384 382
US-A- 4 670 722**

(73) Titulaire : **THOMSON HYBRIDES ET MICROONDES
173, bld Haussmann
F-75008 Paris (FR)**

(72) Inventeur : **Camiade, Marc
Thomson-CSF SCPI 19, avenue de Messine
F-75008 Paris (FR)**
Inventeur : **Bert, Alain
Thomson-CSF SCPI 19, avenue de Messine
F-75008 Paris (FR)**
Inventeur : **Savary, Pierre
Thomson-CSF SCPI 19, avenue de Messine
F-75008 Paris (FR)**

(74) Mandataire : **Taboureau, James et al
THOMSON-CSF SCPI
F-92045 Paris La Défense Cédex 67 (FR)**

**Description**

La présente invention concerne un oscillateur doubleur de fréquence, fonctionnant dans les hyperfréquences, et accordé par varactors. Cet oscillateur ne comporte qu'un seul transistor à effet de champ, dont la fréquence fondamentale est rejetée par un filtre qui favorise la production de l'harmonique 2.

On connait de nombreux types d'oscillateurs hyperfréquence, dont certains sont accordées par des varactors, et qui utilisent un ou plusieurs transistors à effet de champ et une ou plusieurs diodes à capacités variables. On sait faire des oscillateurs commandés par des varactors pour lesquels le rapport fréquence maximale sur fréquence minimale est égal à 2 jusque 18 Ghz environ, mais les limitations pour monter plus haut en fréquence proviennent des varactors, pour lesquels on ne peut pas trop diminuer la surface de puce, donc la capacité, sinon il n'est plus possible de souder les fils de connexion sur ces varactors. En outre les oscillateurs que l'on sait faire utilisent la fréquence fondamentale du transistor qui oscille, et la doublent.

Par opposition, dans l'oscillateur selon l'invention, un seul transistor à effet de champ est utilisé, et si sa grille et sa source comportent des circuits qui sont en soi connus et qui le font osciller sur une fréquence fondamentale, le drain comporte selon l'invention un circuit filtre qui assure la rejection de la fréquence fondamentale et favorise l'émission des harmoniques, en particulier l'harmonique 2. Ce n'est donc pas en doublant la fréquence fondamentale, mais au contraire en l'atténuant et en favorisant la génération de l'harmonique 2 qu'opère l'oscillateur accordable par varactors selon l'invention. Le filtre qui sert à la rejection de la fréquence fondamentale comporte lui aussi un varactor.

De façon plus précise l'invention concerne un oscillateur doubleur de fréquence, fonctionnant dans les hyperfréquences, comportant un transistor à effet de champ dont la fréquence fondamentale d'oscillation est commandée par une impédance de grille comprenant au moins un varactor et par une impédance de source comprenant au moins un varactor, cet oscillateur étant caractérisé en ce qu'il comporte, entre le drain du transistor sur lequel la sortie est prélevée et la masse, un filtre de type LC série constitué par une self et un varactor, ce filtre étant accordé sur la résonance avec la fréquence fondamentale de l'oscillateur.

L'invention sera mieux comprise par la description plus détaillée qui suit, et qui s'appuie sur les figures jointes en annexe qui représentent :

— figure 1 : schéma simplifié d'un oscillateur doubleur selon l'art connu.
— figure 2 : schéma simplifié d'un oscillateur doubleur accordable par varactors selon l'invention.
— figure 3 : schéma électrique détaillé de l'oscillateur doubleur selon l'invention.

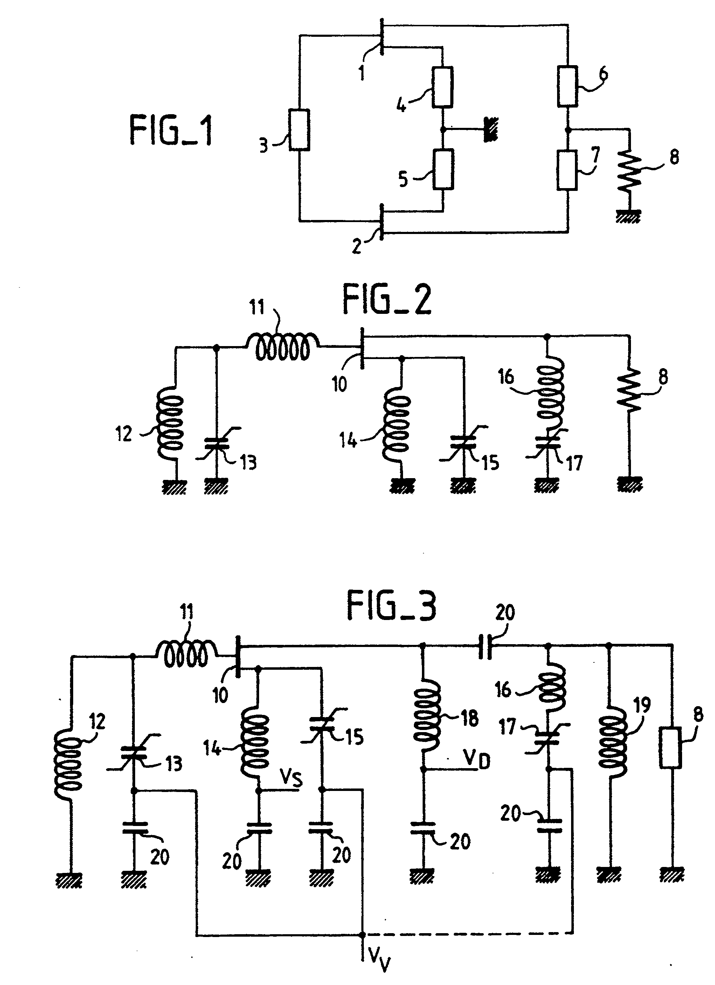

La figure 1 représente le schéma très simplifié d'un oscillateur doubleur tel qu'on en connait de nombreux modèles. Cet oscillateur doubleur fonctionne au moyen de deux transistor à effet de champ 1 et 2, dont la grille est réunie par une impédance commune 3, dont les sources sont réunies entre elles par deux impédances 4 et 5, le point commun à ces deux impédances étant mis à la masse. Les drains des deux transistors 1 et 2 débitent à travers deux impédances 6 et 7, et le point commun à ces deux impédances 6 et 7 fournit un courant sur une charge 8, à une fréquence double de la fréquence d'oscillation fondamentale de chacun des deux transistors 1 et 2. Il n'est pas nécessaire d'entrer dans le détail de ce schéma puisqu'il est déjà connu. Mais cependant il nécessite un certain nombre de conditions difficilement réalisables, ou qui entrainent des inconvénients. Les impédances qui comportent par exemple une self et une diode de capacité variable dite varactor doivent être identiques pour assurer la symétrie de l'oscillateur, par conséquent il faut que les varactors soient eux mêmes identiques. En outre les transistors à effet de champ doivent être parfaitement apairés et avoir les mêmes caractéristiques. Enfin, l'impédance de grille 3 n'est pas positionnée par rapport à la masse, et sa position par rapport à la masse passe à travers les jonctions des transistors à effet de champ 1 et 2 et à travers les impédances 4 et 5 : ceci peut amener des parasites dans la fréquence fournie par cette oscillateur.

Par ailleurs les varactors sont des diodes dont la capacité varie en fonction d'une tension inverse qui leur est appliquée, ces diodes ont donc une certaine surface de puce, et on ne sait pas faire varier la capacité d'un varactor dans un rapport supérieur à 10 environ, c'est à dire que pour $C_{max}$ = 1pF, on a $C_{min}$ = 0,1pF, on ne peut pas pousser au delà parce qu'un tel varactor a un diamètre de table de silicium de l'ordre de 30 microns. Si on réalise des diodes qui sont en structure mésa, dont le diamètre est plus petit que 30 microns, leur capacité serait sans doute inférieure mais on ne saurait plus souder les fils de liaison par thermocompression sur une table aussi petite. C'est pourquoi, dans le domaine de fréquences supérieures à 20 Ghz, on est obligé de réaliser des oscillateurs doubleurs, puisque les varactors existants ne permettent de faire que des oscillateurs à fréquence de sortie inférieure à environ 20 GHz.

Le schéma de la figure 2 est un schéma simplifié de l'oscillateur doubleur de fréquence selon l'invention.

Il ne comporte qu'un seul transistor à effet de champ 10, ce qui élimine déjà les problèmes d'apairage avec d'autres transitors.

Son circuit de grille comporte de façon connue une self série 11 puis un circuit d'accord formé par une self série 12 et un varactor 13 en parallèle avec la self série 12.

Son circuit de source comporte de façon connue une self parallèle 14 et un varactor 15. Les polarisations du transistor et des varactors ne sont pas rapportés sur ce schéma simplifié.

Convenablement polarisé et réglé au moyen des varactors 13 et 15, le transistor 10 fonctionne en oscillateur et fournit une certaine fréquence fondamentale, qui est liée aux valeurs des varactors 13 et 15.

Mais sur sa sortie de drain, qui débite sur une charge 8, un circuit filtre est monté entre le drain et la masse, et il est formé par une self 16 en série avec un varactor 17. Ce circuit de filtre est réglé de telle façon qu'il assure la réjection de la fréquence fondamentale du transistor oscillateur, ce qui de ce fait favorise l'émission des harmoniques, et en particulier l'harmonique 2. Par conséquent la charge 8 reçoit une fréquence qui est le double de la fréquence fondamentale du transistor 10.

Le rôle du troisième varactor 17 est donc :

— de charger le drain du transistor à effet de champ par un court-circuit obtenu par la résonance série de la self 16 et du varactor 17, le fonctionnement non linéaire du transistor à effet de champ est donc accru, la génération d'harmonique est donc améliorée,

— d'annuler la fréquence fondamentale au niveau de la charge d'utilisation.

Le troisième varactor 17 n'intervient que très peu dans la bande d'accord, et si l'oscillateur dans sa partie connue, sur la partie gauche de la figure 2, est conçu pour avoir une large bande d'accord, l'oscillateur selon l'invention avec le circuit 16 et 17 a lui aussi une large bande d'accord. Le varactor 17 doit être adapté à la loi de fréquence en fonction de la tension pour l'oscillateur, et il n'a pas la même loi de capacité en fonction de la tension que les varactors de grille 13 et de source 15.

Concernant la bande d'accord, la présence du varactor de drain 17 augmente l'effet de résistance négative et ne modifie que très peu la fréquence d'oscillation, de l'ordre de 100 à 200 Mhz pour une fréquence d'oscillation de l'ordre de 36 à 40 Ghz.

Les varactors de grille 13 et de source 15 sont préférentiellement des varactors de type hyperabrupt ayant un rapport en capacité égal à 10, tandis que le varactor de drain 17 est préférentiellement un varactor de type abrupt. La bande d'accord étant une octave, il faut que le varactor de drain ait un rapport de capacité égal à 4, puisque la résonance série est donnée par

$$F_r = \frac{1}{2\pi\sqrt{L_D \; C_{VD}}}$$

dans laquelle $F_r$ est la fréquence de résonance du filtre 16 + 17 $L_D$ est la self de drain 16 $C_{VD}$ est la capacité du varactor de drain 17.

Pour ce varactor de drain 17, plus son facteur de qualité est élevé plus la réjection du mode fondamental est bonne. En outre plus le rapport self sur capacité du circuit filtre est faible plus la largeur de bande du filtre est grande. La limitation est apportée par la valeur réalisable de la self 16.

Si la loi de variation de la capacité en fonction de la tension pour le varactor de drain 17 ne correspond pas exactement à la loi de variation de la fréquence en fonction de la tension pour l'oscillateur, on peut ajouter un deuxième réseau LC en parallèle avec le premier, en l'accordant à une fréquence légèrement différente. C'est une façon d'élargir la bande du filtre.

La figure 3 donne le schéma électrique plus détaillé de l'oscillateur doubleur accordable par varactor selon l'invention, les mêmes indices y désignent les mêmes objets que sur la figure 2.

La tension de polarisation de la source VS est appliquée entre la self de source 14 et une capacité 20 qui isole de la masse. De même la tension de polarisation de drain VD est appliquée entre une self de polarisation 18 et une capacité 20 qui l'isole de la masse. Les trois varactors de grille 13 de source 15 et de drain 17 sont commandés par une tension $V_v$, de commande de capacité des varactors, qui est appliquée entre chacun de ces trois varactors et une capacité 20 qui l'isole de la masse. Généralement les utilisateurs préfèrent n'avoir qu'une seule tension de commande $V_v$ pour piloter les trois varactors, mais il peut arriver que la commande de grille et de source soit fixe et que l'on ait besoin de faire varier la commande du varactor de drain 17. C'est pourquoi la liaison a été représentée par un pointillé car il peut éventuellement y avoir deux tensions de variation des varactors. Toutes les capacités de découplage ou de liaison 20 sont de l'ordre de 10 pF.

Le circuit filtre 16 + 17 présente en outre un avantage : il isole l'oscillateur de l'extérieur ce qui fait que si la charge 8 présente une variation d'impédance, pour des raisons quelconques, elle n'influe pas sur la fréquence de l'oscillateur qui reste stable.

L'oscillateur doubleur accordable par trois varactors tel que décrit fonctionne dans une bande de 20 à 40 Ghz, soit dans un domaine supérieur à une octave et donne satisfaction pour la réalisation de sources hyperfréquences.

## Revendications

1. Oscillateur doubleur de fréquence, fonctionnant dans les hyperfréquences, comportant un transistor à effet de champ (10) dont la fréquence fondamentale d'oscillation est commandée par une impédance de grille comprenant au moins un varactor (13) et par une impédance de source comprenant au moins un varactor (15), cet oscillateur étant caractérisé en ce qu'il comporte, entre le drain du transistor sur lequel la sortie est prélevée (10) et la masse, un filtre LC série constitué par une self (16) et un varactor (17), ce filtre étant accordé sur la résonance avec la fréquence fondamentale de l'oscillateur.

2. Oscillateur doubleur selon la revendication 1, caractérisé en ce que le filtre (16 + 17) assure la réjection de la fréquence fondamentale de l'oscillateur, optimise le fonctionnement du transistor (10) en régime non-linéaire, et favorise la génération de l'harmonique 2 de la fréquence fondamentale.

3. Oscillateur doubleur selon la revendication 1, caractérisé en ce que les varactors de grille (13) et de source (15) étant de type hyperabrupt, le varactor de drain (17) est de type abrupt.

4. Oscillateur doubleur selon la revendication 1, caractérisé en ce que la largeur de bande du filtre (16 + 17) est inversement proportionelle au rapport de la self (16) sur la capacité (17) de ses composants.

**Patentansprüche**

1. Frequenzverdoppler-Oszillator, der im Ultrahochfrequenzbereich arbeitet, mit einem Feldeffekttransistor (10), dessen Oszillations-Grundfrequenz von einer wenigstens eine Reaktanzdiode (13) aufweisenden Gate-Impedanz und von einer wenigstens einer Reaktanzdiode (15) aufweisenden Source-Impedanz gesteuert wird, wobei dieser Oszillator dadurch gekennzeichnet ist, daß er zwischen dem Drain des Transistors (10), an dem die Ausgabe abgegriffen wird, und der Masse ein Reihen-LC-Filter, das von einer Drosselspule (16) und einer Reaktanzdiode (17) gebildet wird, aufweist, wobei dieses Filter auf die Resonanz mit der Oszillator-Grundfrequenz abgestimmt ist.

2. Verdoppler-Oszillator gemäß Anspruch 1, dadurch gekennzeichnet, daß das Filter (16 + 17) die Unterdrückung der Oszillator-Grundfrequenz gewährleistet, den nicht linearen Betrieb des Transistors (10) optimiert und die Erzeugung der 2. Harmonischen der Grundfrequenz fördert.

3. Verdoppler-Oszillator gemäß Anspruch 1, dadurch gekennzeichnet, daß dann, wenn die Reaktanzdioden des Gates (13) und der Source (15) vom hyperschnellen Typ sind, die Reaktanzdiode des Drains (17) vom schnellen Typ ist.

4. Verdoppler-Oszillator gemäß Anspruch 1, dadurch gekennzeichnet, daß die Bandbreite des Filters (16 + 17) umgekehrt proportional zum Verhältnis der Drosselspule (16) und der Kapazität (17) seiner Bestandteile ist.

## Claims

1. A frequency doubling oscillator, functioning in the microwave region, comprising a field effect transistor (10) whose fundamental frequency of oscillation is controlled by a gate impedance comprising at least one varactor (13) and by a source impedance comprising at least one varactor (15), said oscillator being characterized in that it comprises, between the drain of the transistor (10) at which the output is connected and ground, a series LC filter constituted by an inductance (16) and a varactor (17), said filter being tuned to have its resonance corresponding to the fundamental frequency of the oscillator.

2. The doubling oscillator as claimed in claim 1, characterized in that the filter (16 and 17) ensures the rejection of the fundamental frequency of the oscillator, optimizes the function of the transistor (10) in the non-linear range and favors the generation of the second harmonic of the fundamental frequency.

3. The doubling oscillator as claimed in claim 1, characterized in that the gate varactors (13) and the source varactor (15) being of the hyberabrupt type, the drain varactor (17) is of the abrupt type.

4. The doubling oscillator as claimed in claim 1, characterized in that the width of the band of the filter (16 and 17) is inversely proportional to the ratio of the inductance (16) with respect to the capacitance (17) of its components.

FIG_1

FIG_2

FIG_3